# EUROPEAN PATENT SPECIFICATION

(11) **EP 2 590 309 B1**
(45) Date of publication and mention of the grant of the patent: **18.06.2014**
(21) Application number: 12190662.2
(22) Date of filing: 30.10.2012
(51) Int. Cl.: H02M 7/00

(54) **Semiconductor power module**
Leistungshalbleitermodul
Module d'alimentation à semi-conducteur

(30) Priority: 02.11.2011 JP 2011241405
(43) Date of publication of application: 08.05.2013
(73) Proprietor: Hitachi, Ltd., Chiyoda-ku Tokyo 100-8280 (JP)
(72) Inventor: Horiuchi, Keisuke, Tokyo, 100-8220 (JP); Nishihara, Atsuo, Tokyo, 100-8220 (JP); Mori, Mutsuhiro, Tokyo, 100-8220 (JP); Nemoto, Yasuhiro, Tokyo, 100-8220 (JP); Azuma, Katsunori, Tokyo, 100-8220 (JP)
(74) Representative: MERH-IP Matias Erny Reichl Hoffmann

(56) References cited:
- EP-A1- 1 376 696
- US-A1- 2007 252 265
- US-B1- 6 215 681

## Description

### BACKGROUND

### 1. Technical Field

The present invention relates to a semiconductor device, more particularly to a semiconductor power module used for a inverter/converter.

### 2. Related Art

Recent years, production of hybrid electric vehicles and electric vehicles is increasing. For these vehicles, a system of converting DC supplied from batteries into AC by a inverter/converter to drive a motor is typically used. A semiconductor power module mounted on this inverter/converter is to convert AC to DC by switching a semiconductor power device such as an IGBT (Insulated Gate Bipolar Transistor).

The semiconductor power module is typically used by connecting a switching transistor and a diode (this set is called an arm) in parallel. This set of semiconductors connected between a positive terminal and an AC terminal is called an upper arm and the same connected between an AC terminal and a negative terminal is called a lower arm. A single-phase AC power can be output by combining the upper arm and the lower arms. Thus, three sets of upper and lower arms (six arms in total) are required to generate a three-phase AC.

Various drive systems are proposed for hybrid electric vehicles. For example, in a system equipped with a motor driving electricity and a generator for an electricity regenerator separately, two systems of inverter/converter i.e., one for driving power and the other for power regeneration are required. To convert two systems of three-phase AC to DC, two groups of semiconductors composed of the abovementioned three sets of upper and lower arms and a total of 12 arms of semiconductor power devices are required.

Furthermore, in the case where a switched reluctance motor (SR motor) is employed for driving a vehicle, for example, for a motor with four pole rotor and six pole stator it is necessary to supply power from the six stator terminals to drive one motor and the upper and lower arms are required for output of one AC terminal, thus requiring 12 arms of power semiconductors for inversion/conversion. Accordingly, depending on the driving system of a hybrid vehicle, a inverter/converter composed of 12 arms may be required.

Meanwhile, a technology of mounting a power semiconductor composed of 12 arms within a case and thereby making a semiconductor module (hereafter referred to as a 12-in-1 module) is disclosed in, for example, JP-A-2007-336643. Also, a inverter/converter composed of six semiconductor modules, each of which is composed of one set of upper and lower arms and thus six semiconductor modules are composed of 12 arms is disclosed in, for example, JP-A-2009-219270, which presents a circuit configuration of a semiconductor module and an arrangement of components thereof.

Patent Application US 2007/0252265 shows another prior art example of a power semiconductor module as H-bridge circuit.

### SUMMARY

General-purpose semiconductor power modules are typically of 1-in-1 to 6-in-1 types, which composed of up to six arms of semiconductor devices mounted in a case and a 12-in-1 module has relatively complex circuit configuration. Accordingly, for compactly mounting the 12-in-1 module it is necessary to elaborate a layout thereof.

Meanwhile, the configuration disclosed in the above JP-A-2007-336643 is an example of mounting the module compactly with an elaborated layout, where one system of AC terminals (three terminals of U, V, and W) are disposed on one side of the module and the other system of three AC terminals on the opposite side. Further, a DC terminal is so formed that connection thereto is made from the center of a top surface of the module. Also, a semiconductor module according to the above JP-A-2009-219270 is a 2-in-1 module where a positive terminal, a negative terminal, an AC terminal, and a gate terminal are all disposed on the top surface of the semiconductor module.

However, in a typical configuration of a vehicle, it is often preferred that all AC terminals are grouped together on one side and DC terminals are on the other side. The reason is that, in many cases, motors and generators to be connected to AC terminals are disposed around an engine and a transmission and batteries to be connected to DC terminals are disposed away from the engine. Also, the reason why it is preferred not to dispose the DC terminals at the center of the top surface of the semiconductor power module is that since control signal terminals are disposed on the top surface, if bus bars and control signal lines of DC are disposed on the same side disposition of control signal pins is more restricted.

Another problem is to reduce inductance of a power circuit. Product of the inductance of a power circuit and the current change rate determines surge voltage. Since it is necessary to suppress the surge voltage below dielectric strength voltage of a component, upper limit of current change rate is determined according to inductance value. However, since it is advantageous to increase current change rate for increasing power conversion efficiency, it is desirable to reduce circuit inductance as far as possible.

The present invention is made to address the above problems and an object of the present invention is to mount a plurality of arms including, for example, 12 arms on a single semiconductor power module in a compact, simple, and easy to mount form, to dispose terminals on the edge of the module so that DC, AC, and control signals can be easily connected to the respective terminals, and to provide a semiconductor power module capable of keeping the inductance of a power circuit thereof at a low level.

To address the above problems the present invention employs the following configuration.

The present invention is mainly characterized by a 12-in-1 configuration wherein two sets of upper arms are disposed on upper right and left sides of an insulated substrate and two sets of lower arms are disposed on lower right and left sides, the two sets of upper arms are mounted on a first wiring pattern as a wiring pattern on the insulated substrate, the two sets of lower arms are a second and third wiring patterns disposed under the first wiring pattern, the first wiring pattern extend between the second and third wiring patterns, wiring from a positive terminal is connected to an edge of the extended wiring pattern, and three boards of the substrate are mounted in parallel in one module.

Specifically, a semiconductor power module of the present invention includes: one insulated substrate mounted on a metal base; first to fourth switching transistors and first to fourth diodes mounted on the insulated substrate; a first upper arm to which the first switching transistor and the first diode are connected in reverse-parallel; a second upper arm to which the second switching transistor and the second diode are connected in reverse-parallel; a first lower arm to which the third switching transistor and the third diode are connected in reverse-parallel; a second lower arm to which the fourth switching transistor and the fourth diode are connected in reverse-parallel; a first DC terminal to which an end of a series-connected circuit of the first upper arm and the first lower arm and an end of a series-connected circuit of the second upper arm and the second lower arm is connected; a second DC terminal to which the other end of the series-connected circuit of the first upper arm and the first lower arm and the other end of the series-connected circuit of the second upper arm and the second lower arm is connected; a first AC terminal to which a series-connection point of the first upper arm and the first lower arm; and/or a second AC terminal to which a series-connection point of the second upper arm and the second lower arm, wherein:
a first column composed of the first upper arm and the first lower arm and a second column composed of the second upper arm and the second lower arm are disposed rough-axisymmetrically across a column center line on the insulated substrate so that the first column and the second column face orthogonally to the columns; and/or the first DC terminal and the second DC terminal are disposed at one end of the first column and one end of the second column respectively and the first AC terminal and the second AC terminal are disposed on another end thereof.

Also, in the semiconductor power module: on the insulated substrate, the switching transistor and the diode are mounted or a plurality of wiring patterns serving as bonding points for wire bonding or metal bonding are formed; and when the first and second DC terminals are disposed on an edge of a semiconductor power module on the first and second lower arm side: the first and second upper arms are respectively mounted on a first wiring pattern, the first lower arm is mounted on a second wiring pattern, and the second lower arm is mounted on a third wiring pattern; an extended portion of the first wiring pattern is formed between the second wiring pattern and the third wiring pattern which are separately formed across the column center line of the insulated substrate and wiring for bonding from a positive terminal that is the first DC terminal is connected to an end of the extended portion; and wiring for bonding from a negative terminal that is the second DC terminal is connected to a fourth wiring pattern.

According to an aspect of the present invention, it is possible to mount a 12-in-1 semiconductor power module compactly. Therefore, a inverter/converter requiring 12 arms can be made of a single semiconductor power module and thereby the inverter/converter can be manufactured compactly and at a lower cost.

Further, since inductance of the power circuit can be reduced, current change rate at power conversion can be increased and thus it is possible to increase the efficiency of power conversion. This improves fuel efficiency of a vehicle and also reduces heat generated due to the loss, making it possible to downsize a cooling system of the semiconductor power module and thereby reduce the cost.

### BRIEF DESCRIPTION OF THE DRAWINGS

Fig. 1 is a plain view showing a configuration of components of a semiconductor power module according to a first embodiment of the present invention;
Fig. 2 is a perspective view showing an overall structure of the semiconductor power module and cooling system according to the first embodiment of the present invention;
Fig. 3 is a perspective view showing the overall structure in Fig. 2 of the semiconductor power module with a lid thereof removed;
Fig. 4 is a perspective view showing a configuration of components of two-phased semiconductor power module according to the first embodiment;
Fig. 5 is a diagram showing a circuit configuration of the semiconductor power module according to the first embodiment;
Fig. 6 is a partial cutaway view of the semiconductor power module according to the first embodiment;
Fig. 7 is a perspective view showing a configuration of the two-phased semiconductor power module according to a second embodiment of the present invention;
Fig. 8 is a plain view showing a configuration of components of the semiconductor power module according to the second embodiment;
Fig. 9 is a perspective view showing overall structure of the semiconductor power module with a lid thereof removed according to a third embodiment of the present invention;
Fig. 10 is a perspective view showing a configuration of components of two-phased semiconductor power module according to the third embodiment;
Fig. 11 is plain view showing a configuration of components of the semiconductor power module according to the third embodiment;
Fig. 12 is a perspective view showing a configuration of components of the two-phased semiconductor power module according to a fourth embodiment;
Fig. 13 is a plain view showing a configuration of components of the semiconductor power module according to the fourth embodiment;
Fig. 14 is a perspective view showing a configuration of components of the two-phased semiconductor power module according to a fifth embodiment; and
Fig. 15 is a plain view showing a configuration of components of the semiconductor power module according to the fifth embodiment.

### DETAILED DESCRIPTION

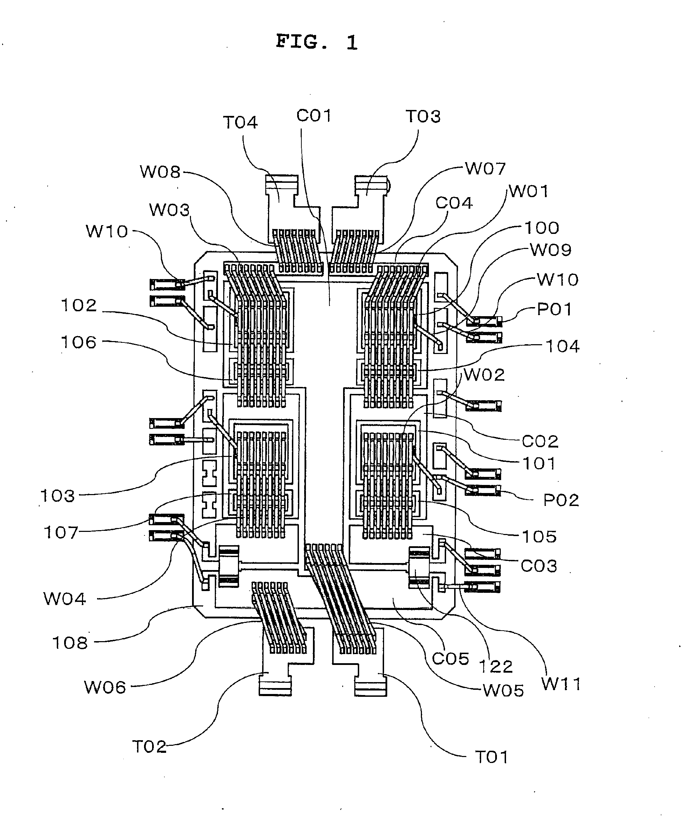

Semiconductor power modules according to respective embodiments of the present invention are described with reference to the drawings. A first embodiment of a semiconductor power module of the present invention is described with reference to Figures 1 to 6, a second embodiment is described in detail with

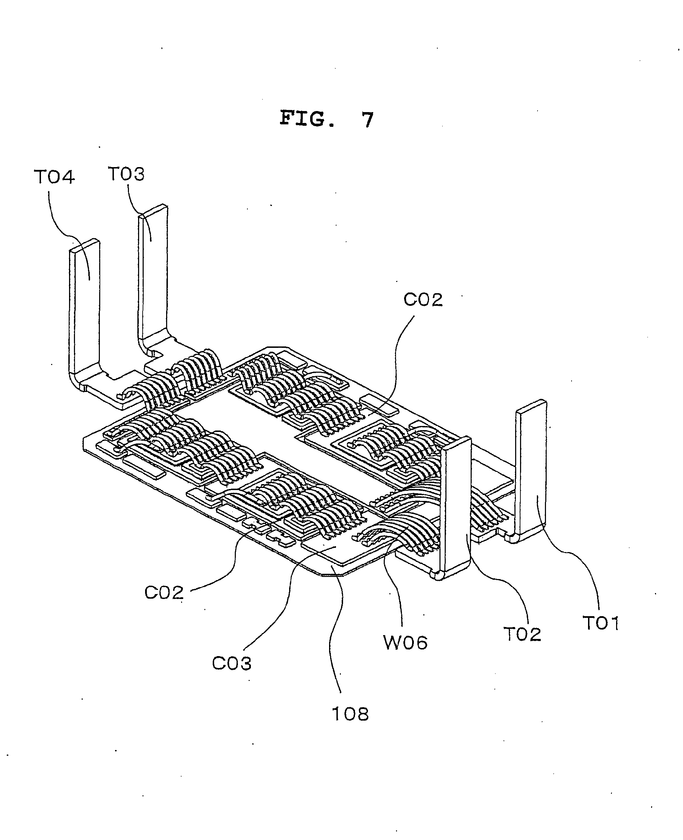

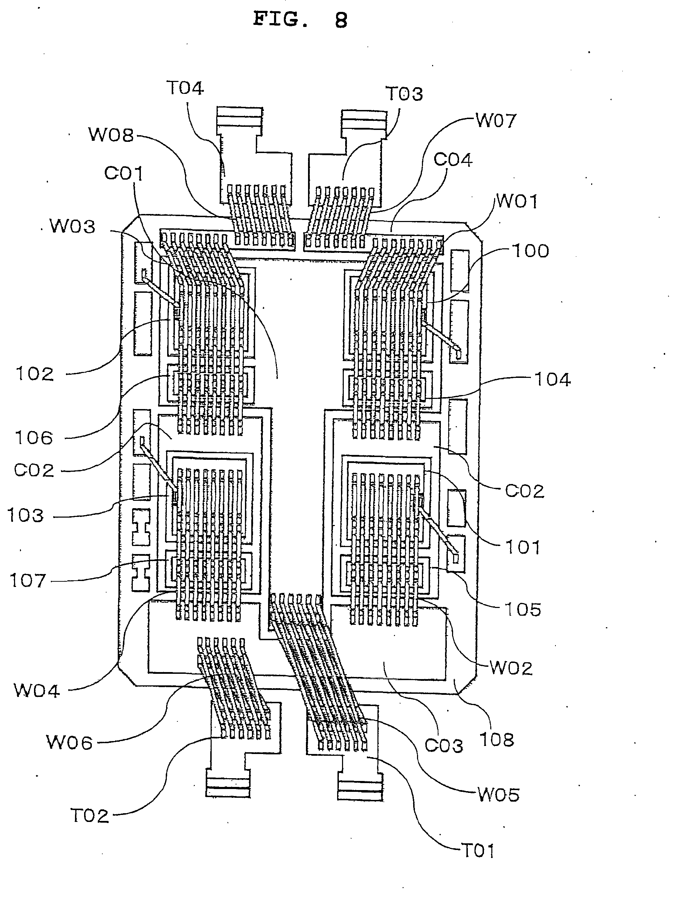

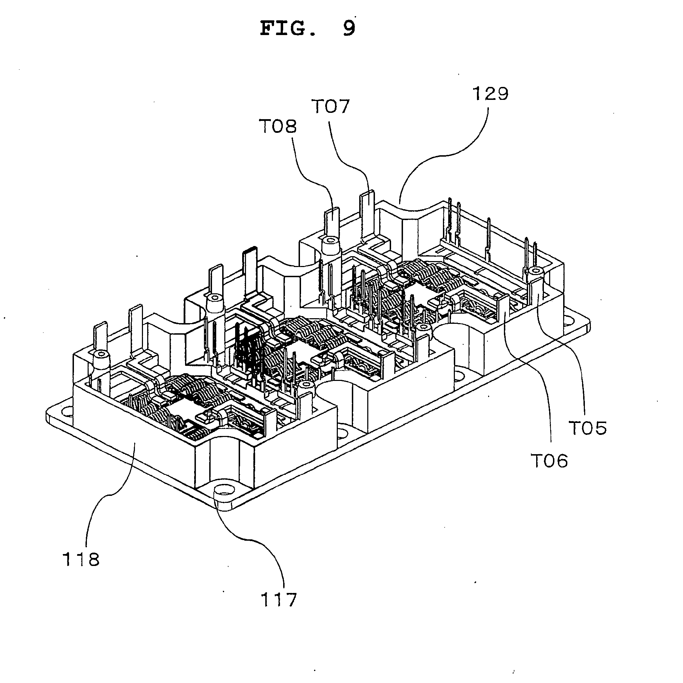

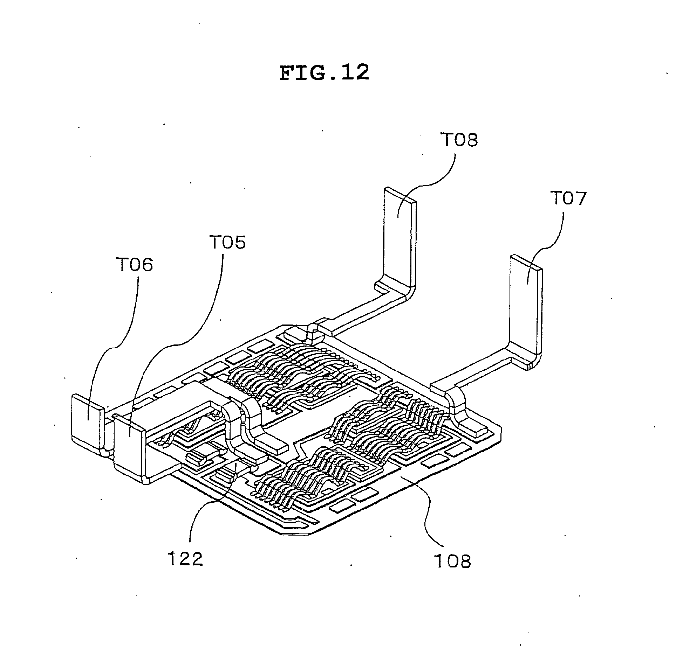

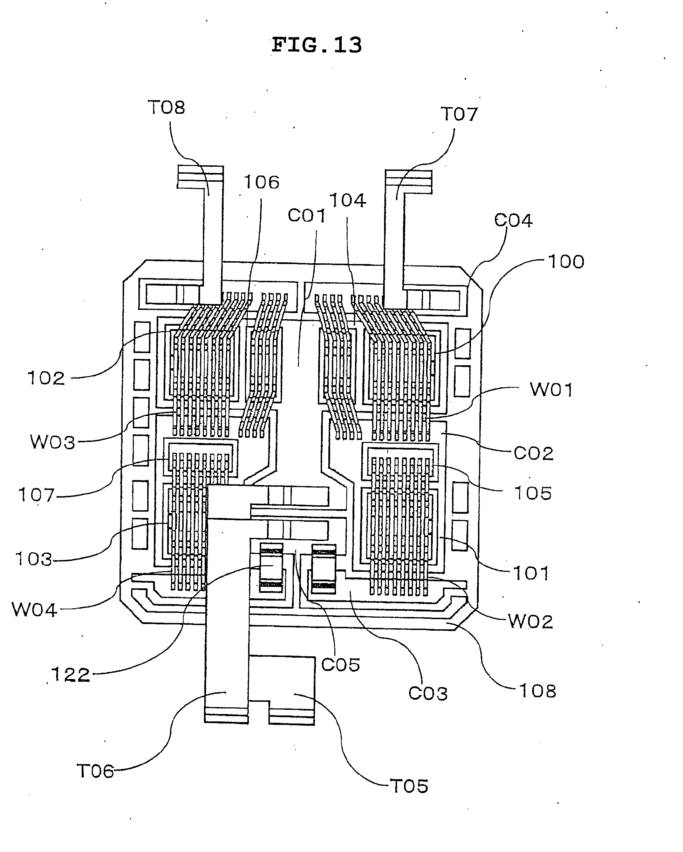

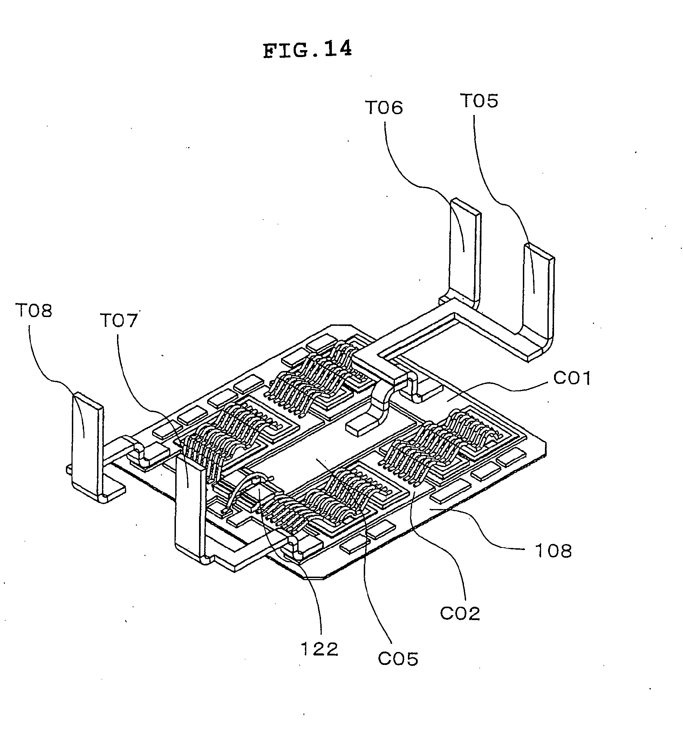

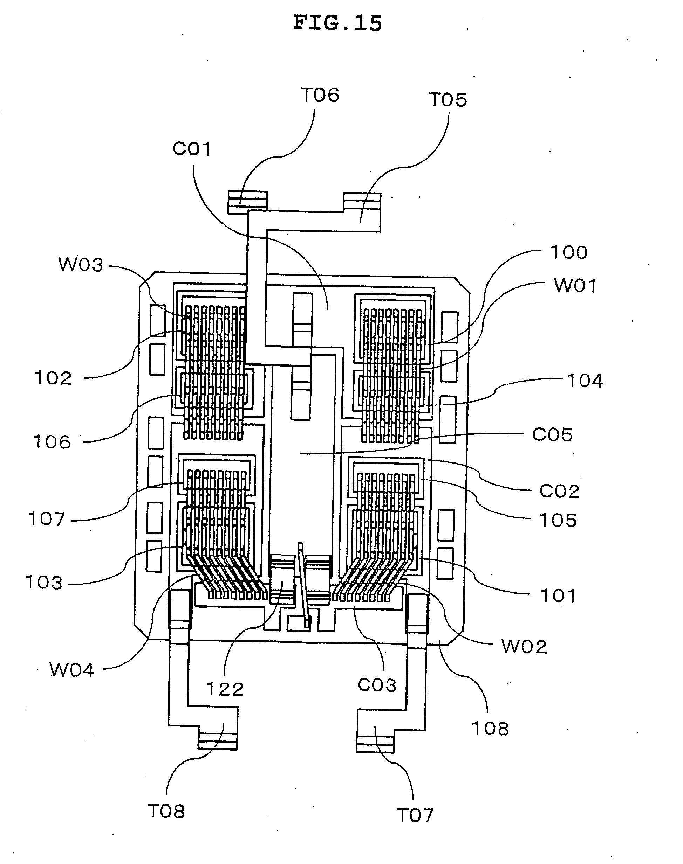

Figures 7 and 8, a third embodiment is described with Figures 9 to 11, a fourth embodiment is described with Figures 12 and 13, and a fifth embodiment is described with Figures 14 and 15. In the descriptions of the respective embodiments, the basic functions of the components (IGBT, diode, arm, terminal, etc.) of the semiconductor power module of related art in the patent documents described in the Background Arts herein are the same also in the embodiments described below.

### First Embodiment

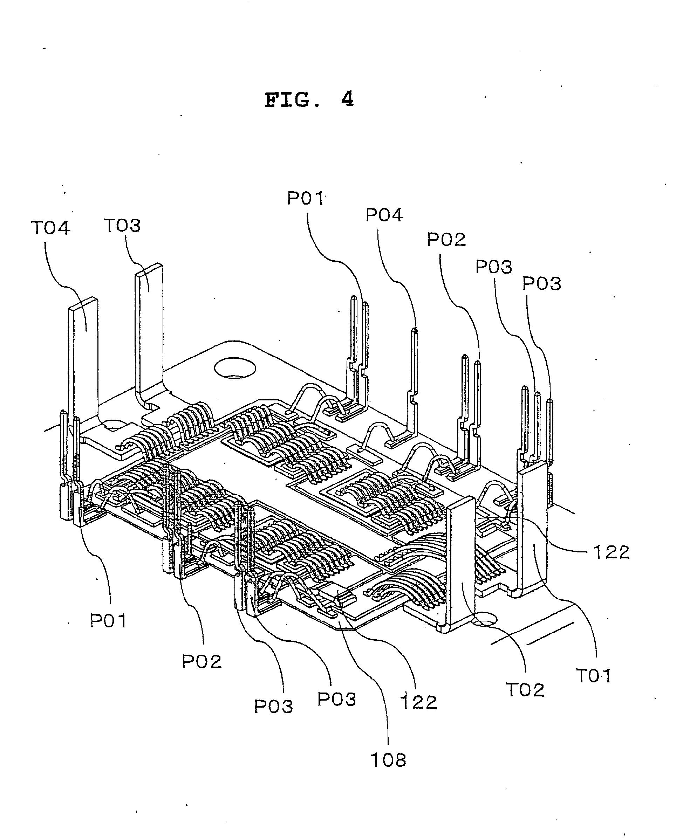

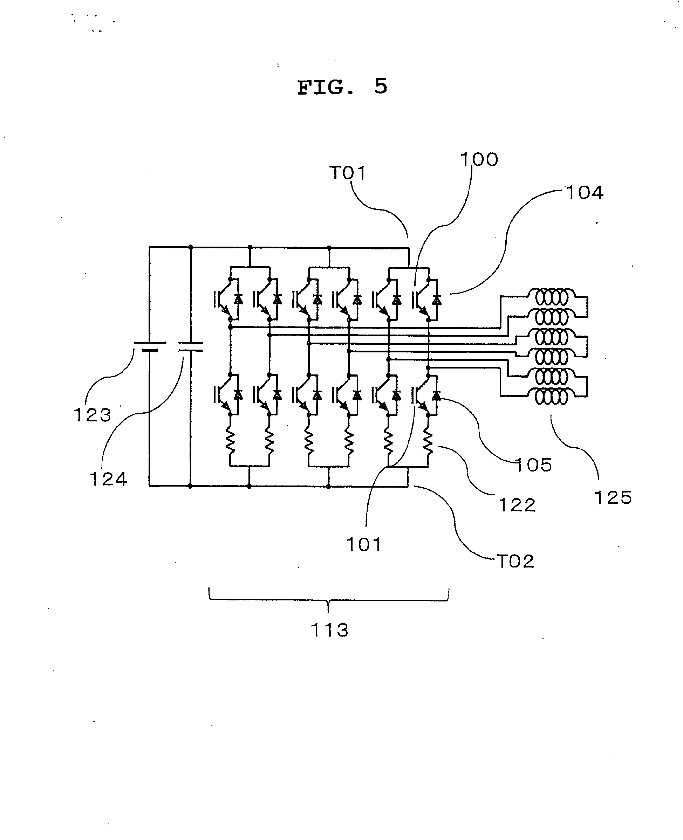

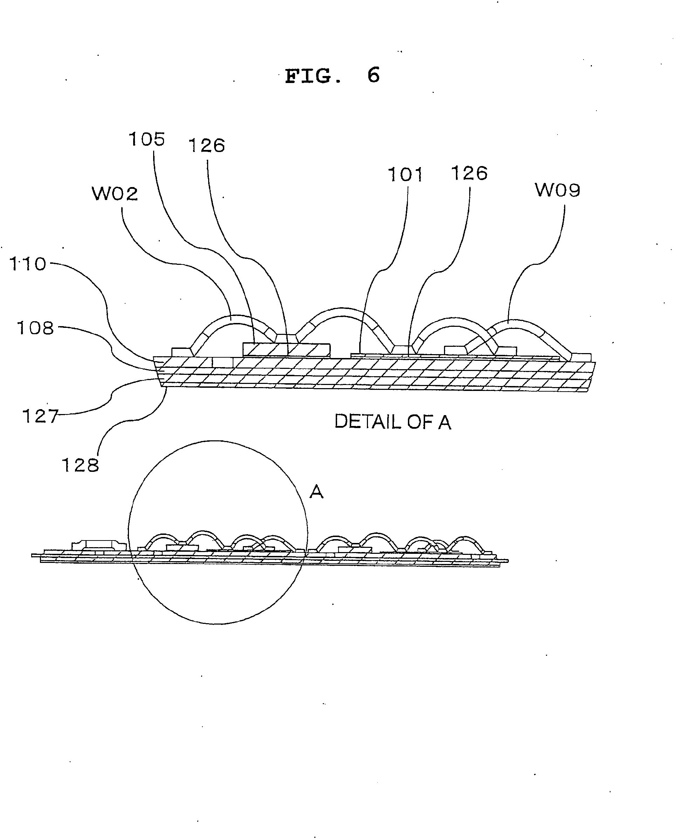

Fig. 1 shows a layout of a semiconductor power module of a first embodiment mounted on an insulated substrate. IGBTs 100 to 103 and diodes 104 to 107 are mounted on insulated substrate 108, and IGBTs 100 to 103, diodes 104 to 107, wiring patterns C01 to C05, power terminals T01 to T04, and signal pins P01 to P04 (see Fig. 4) are respectively connected by bonding wires W01 to W11. In the embodiment of Fig. 1, a set of IGBT 100 and diode 104 constitutes one arm and thus a total of four arms are mounted on one insulated substrate 108 (see also Figures 5 and 6 described below).

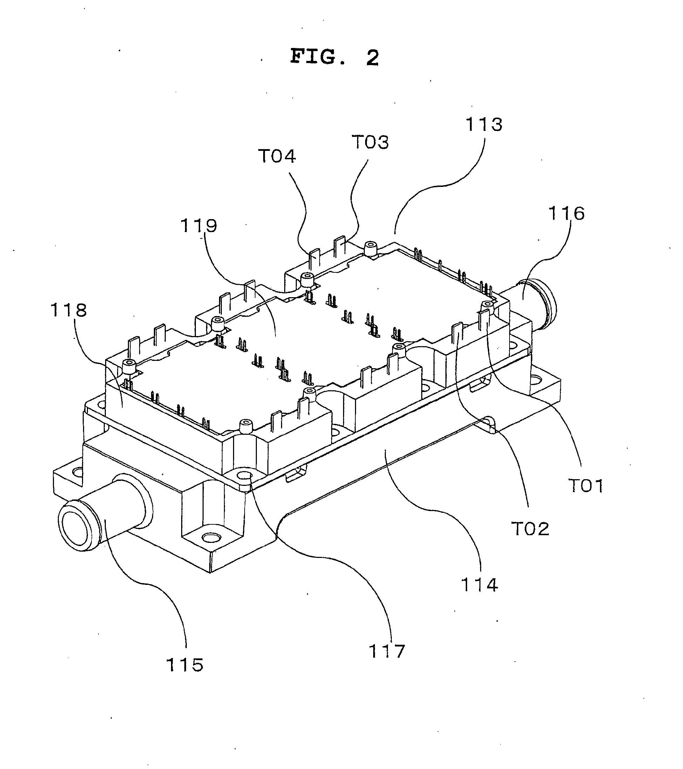

Fig. 2 is a perspective view of a semiconductor power module of this embodiment mounted on a cooling system. By mounting semiconductor power module 113 on cooling system 114 and flowing cooling water from inlet 115 to outlet 116 heat generated due to the loss of semiconductor power module 113 is removed.

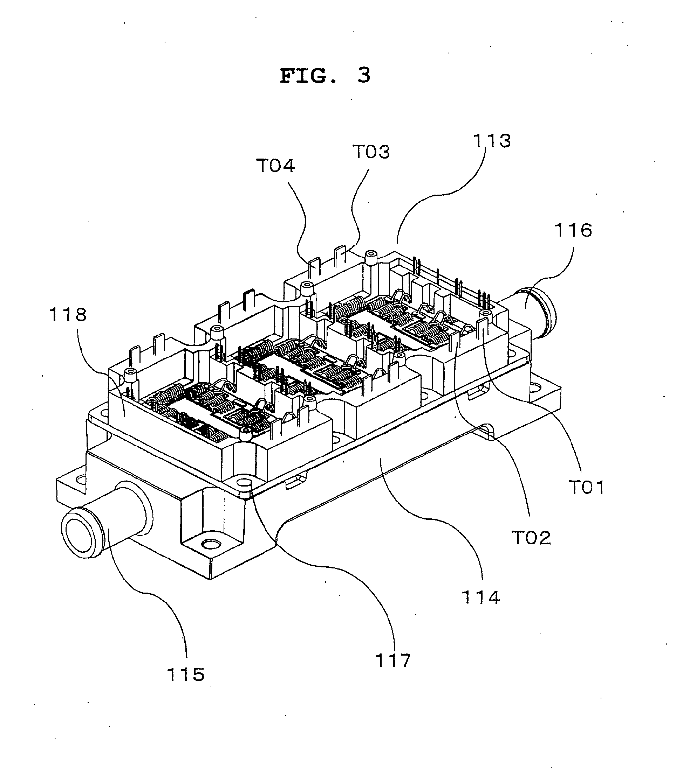

Fig. 3 shows the semiconductor power module of Fig. 2 with lid 119 removed. In semiconductor power module 113, three boards of insulated substrates 108 shown in Fig. 1 are mounted, constituting a 12-in-1 module containing a total of 12 arms. Thought not shown, actually gel is filled in case 118 to ensure the insulation between wirings. Although three insulated substrates 108 are disposed in parallel in the shown embodiment, a plurality of insulated substrates may be disposed in parallel.

Fig. 4 shows a wiring inside one board of insulated substrate with case 118 of Fig. 3 removed (actually, terminals T01 to T04 and pins P01 to P03 are insert-molded in case 118 and thus it is impossible to remove case 118 as in Fig. 4). Fig. 1 is a plain view of the wiring of Fig. 4 seen from above.

Of four power terminals, T01 is a positive terminal, T02 is a negative terminal, and T03 and T04 are AC terminals. For signal pins, P01 and P02 are gate signal pins, P03 is a voltage detection pin for shunt resistor 122, and the other pins P04 are voltage detection pins for various components. Shunt resistor 122 is used to measure current value by detecting voltage difference between both ends thereof.

Fig. 5 is a main circuit diagram of a motor drive system configuration example to be applied to this embodiment. DC power to be supplied from battery 123 is converted to AC by semiconductor power module 113 to drive motor 125. At that time, the fluctuating current component of a DC line is absorbed in smoothing capacitor 124 to smooth the current. In the example of Fig. 5, since motor 125 is a switched reluctance motor it is necessary to supply AC individually to six poles of a stator. Accordingly, a inverter/converter equipped with 12 arms as shown in Fig. 5 is required.

Fig. 6 is a cutaway view of insulated substrate 108 on which semiconductor devices. Insulated substrate 108 is provided with wiring copper pattern 110 on top and solid-filling copper pattern 127 on back. On wiring pattern 110 (corresponding to C02 in Fig. 1), IGBT 101 and diode 105 are mounted using solder 126. Also, insulated substrate 108 is connected to copper base 117 (see Fig. 3) using solder 128.

Wiring patterns C01 to C05 are described also with reference to Fig. 1. Wiring pattern C01 is a pattern including the upper half portion and central longitudinal portion on insulated substrate 108 in the configuration example shown in Fig. 1, and IGBT 100 and diode 104 (upper arm) are mounted on the right side of the upper half portion and IGBT 102 and diode 106 (upper arm) are mounted on the left side of the upper half portion. Wiring pattern C02 is a pair of wiring patterns disposed on the right and left sides of the central longitudinal portion of wiring pattern C01, and IGBT 101 and diode 105 (lower arm) are mounted on the right side thereof and IGBT 103 and diode 107 (lower arm) are mounted on the left side thereof.

Wiring pattern C03 is a pair of right and left wiring patterns to be connected to right and left lower arms by wire bondings W04 and W02. Wiring pattern C04 is a pair of right and left wiring patterns to be connected to right and left upper arms by wire bondings W03 and W01 and this wiring pattern C04 is connected to AC terminals T03 and T04 by wire bondings W07 and W08. Wiring pattern C05 is a wiring pattern disposed at the lowest area of insulated substrate 108 in the example of Fig. 1 and is connected to negative terminal T02 by wire bonding W06 and connected to wiring pattern C03 via shunt resistor 122.

Next, connections between components of a semiconductor power module of the first embodiment are described with reference to Fig. 1, Fig. 4, Fig. 5 and Fig. 6. On a board of insulated substrate 108 to be mounted on metal base 127, a first upper arm in which first to fourth switching transistors (IGBT) 100 to 103, first to fourth diodes 104 to 107, first switching transistor 100 and first diode 104 are connected in reverse-parallel, a second upper arm in which second switching transistor 102 and second diode 106 are connected in reverse-parallel, first lower arm in which third switching transistor 101 and third diode 105 are connected in reverse-parallel, and a second lower arm in which fourth switching transistor 103 and fourth diode 107 are connected in reverse-parallel are mounted.

Further, the first upper arm and the first lower arm are connected in series, the second upper arm and the second lower arm are connected in series, one end of the series-connected circuit of the first upper arm and the first lower arm and one end of the series-connected circuit of the second upper arm and the second lower arm are connected to positive terminal T01 (first DC terminal), the other end of the series-connected circuit of the first upper arm and the first lower arm and the other end of the second upper arm and the second lower arm are connected to negative terminal T02 (second DC terminal). Also, first AC terminal T03 is connected to the series-connected point of the first upper arm and the first lower arm and second AC terminal T04 is connected to the series-connected point of the second upper arm and the second lower arm.

In the connection between components of the abovementioned semiconductor power module, the first column (the right-side column in the example of Fig. 1) composed of the first upper arm and the first lower arm and the second column (the left-side column in the example of Fig. 1)composed of the second upper arm and the second lower arm disposed roughly in parallel, and also the first column and the second column are disposed rough-axisymmetrically about wiring pattern C01 (across the column center line of insulated substrate 108) so that the first upper arm and the second upper arm face each other in horizontal direction shown in the figure i.e., in a direction perpendicular to the column and also the first lower arm and the second lower arm face each other in horizontal direction shown in the figure i.e., in a direction perpendicular to the column. Positive terminal T01 (the first DC terminal) and negative terminal T02 (the second DC terminal) are disposed together at each one end of the first and second columns (one end of semiconductor power module 113 shown in Fig. 2), and first AC terminal T03 and second AC terminal T04 are disposed together at the other end thereof (the other end of semiconductor power module 113 shown in Fig. 2).

The reason for the DC and AC terminals are disposed as described above in a semiconductor power module is that, in a typical vehicle structure, it is convenient to dispose all AC terminals together in the same direction and dispose DC terminals in the opposite side of AC terminals, and a motor and a generator to be connected to the AC terminals are disposed together around a transmission and a battery to be connected to the DC terminal are disposed away from the engine in many cases. Also, the reason why it is convenient not to dispose the DC terminal at the center of the top surface of a semiconductor power module is that because control signal terminals are disposed on the top surface, if DC electricity busbars and control signal lines are disposed in the same direction restrictions on the disposition of pins increase.

Now, operation of the semiconductor power module according to the first embodiment of the present invention is described with reference to Fig. 1 and Fig. 5. Since AC terminals T03 and T04 output AC, current inflow and outflow is repeated according to phase. First, operation of the semiconductor power module when current outflows from AC terminal T03 is described. At this time, DC is supplied from positive terminal T01 and flowed to wiring pattern C01 via bonding wire W05. Here, when IGBT 100 of the upper arm is turned on by applying gate current to gate signal pin P01, the current passes IGBT 100 from back to front and flows to wiring pattern C04 via bonding wire W01. Also, current flows out from AC terminal T03 via wire W07.

When the voltage at gate signal pin 01 drops and IGBT 100 turns off, the current from wiring pattern C01 is cut off. At this time, feedback current from negative terminal T02 flows from wiring pattern C05 via bonding wire W06 and passes diode 105 of the lower arm from front to back to wiring pattern C02 through shunt resistor 122 and wiring pattern C03 and wire W02. After the current flowed from wiring pattern C02 to wire W01, it flows out from AC terminal T03 along the same path as mentioned.

When current flows in from AC terminal T03, IGBT 101 of the lower arm and diode 104 of the upper arm operate and the current flows following almost the same procedure as described above.

Accordingly, it is possible to control the connection from DC terminals T01 and T02 to AC terminal T03 by controlling applied voltage to gate signal pins P01 and P02, and it is also possible to generate current of any frequency by PWM (Pulse Width Modulation) that controls the width of a voltage pulse.

Thus, it is possible to output single phase AC from terminal T03 with a set of IGBTs 100 and 101 and diodes 104 and 105. Likewise, it is possible to output another single phase AC from terminal T04 with a set of IGBTs 102 and 103 and diodes 106 and 107, which means insulated substrate 108 is composed of four arms capable of output two phase AC.

Since three insulated substrates 108 are mounted in one semiconductor power module 113, semiconductor power module 113 is composed of 12 arms in total. Consequently, using semiconductor power module 113 of this embodiment enable a inverter/converter that converts six-phase AC to DC to be made of one semiconductor power module 113.

Further, according to the first embodiment, it is possible to concentrate AC terminals T03 and T04 on one side of semiconductor power module 113 (see Fig. 2) and dispose DC terminals T01 and T02 together on the opposite side. Also, it is possible to dispose signal pins P01 to P04 on the central top of semiconductor power module 113 to prevent the interference with power terminals T01 to T04.

As mentioned in the Summary of the Invention, there is a demand for reduction of the inductance of a power circuit and as a method for satisfying this demand, in the right half circuit including IGBTs 100 and 101 a clockwise loop is formed that makes recovery current flow to negative terminal 102 via positive terminal T01, wiring pattern C01, arms 100 and 104, arms 101 and 105, and wiring pattern C05, in the first embodiment. In the left half circuit including IGBTs 102 and 103, a counterclockwise loop along which recovery current flows. Thus, a clockwise loop and a counterclockwise loop are formed in the power circuit on insulated substrate 108 and these two loops can cancel each other's inductance, enabling the reduction of the inductance inside the semiconductor power module.

Although IGBT is used as a switching transistor in this embodiment, other switching transistors such as MOSFET and bipolar transistor may be used (this is true of the other embodiment described below).

### Second Embodiment

A second embodiment of the present invention is a configuration example wherein shunt resistor 122 for current measurement (shown in Fig. 1) is not used and a current sensor is provided outside of semiconductor power module and shunt resistor 122 is not included within semiconductor power module 113. Fig. 7 is a perspective view showing a wiring inside one insulated substrate 108 of the second embodiment. Fig. 8 is a plain view of insulated substrate 108 of Fig. 7 seen from above. Here, the descriptions of the configuration with the same numerals as in Figures 1 to 6 and the parts having the same functions as in these figures are omitted.

Wiring patterns on the negative pole divided into C03 and C05 in the first embodiment (see Fig. 1) are put together into one wiring pattern like C03 shown in Fig. 8. Also, bonding wire W06 from negative terminal T02 and bonding wires W02 and W04 from the lower arm are all connected to wiring pattern C03. Thus, the wiring patterns on the negative pole are simplified and thereby vertical size of the insulated substrate can be reduced.

Specifically, in the second embodiment, on one insulated substrate 108, switching transistors 100 to 103 and diodes 104 to 107 are mounted or a plurality of wiring patterns C01 to C04 are formed that serve as bonding points, and when the first and second DC terminals (T01 and T02) are disposed on the first and second arm side, the first and second upper arms (100,104 and 102,106)are mounted respectively on a first wiring pattern C01, the first lower arm is mounted on the second wiring pattern (right C02), the second lower arm is mounted on the third wiring pattern (left C02), the extended portion of the first wiring pattern C01 is formed between the second wiring pattern (right C02) and the third wiring pattern (left C02) that are formed on the right and left sides of the column center line of insulated substrate 108, wires for wire bonding from positive terminal T01 that is the first DC terminal are connected at the end of the extended portion, and wires for wire bonding from negative terminal T02 that is the second DC terminal is connected to the fourth wiring pattern C03. This configuration corresponds to that without wiring pattern C03 to which shunt resistor 122 shown in Fig. 1 is connected.

### Third Embodiment

A third embodiment of the present invention is a configuration example of the semiconductor power module wherein power terminals T05 to T08 (corresponding to T01 to T04 of the first embodiment) are connected by metal bonding, not wire bonding.

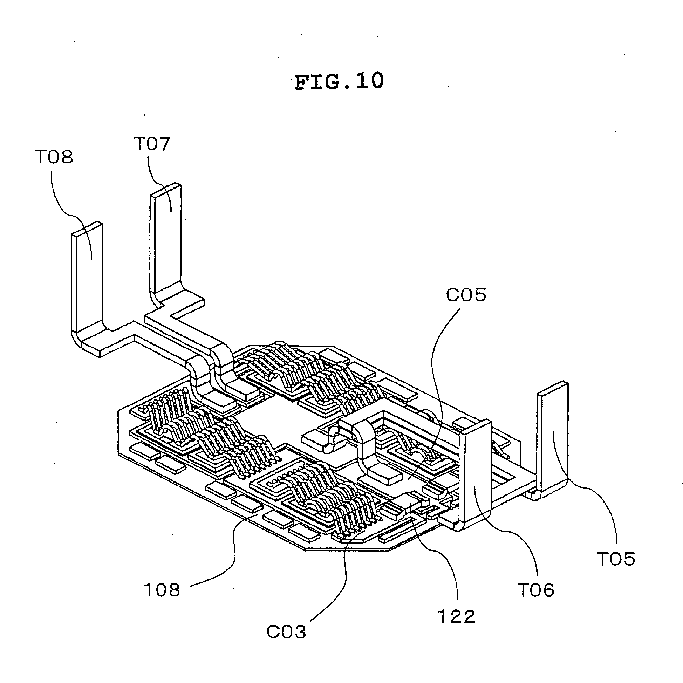

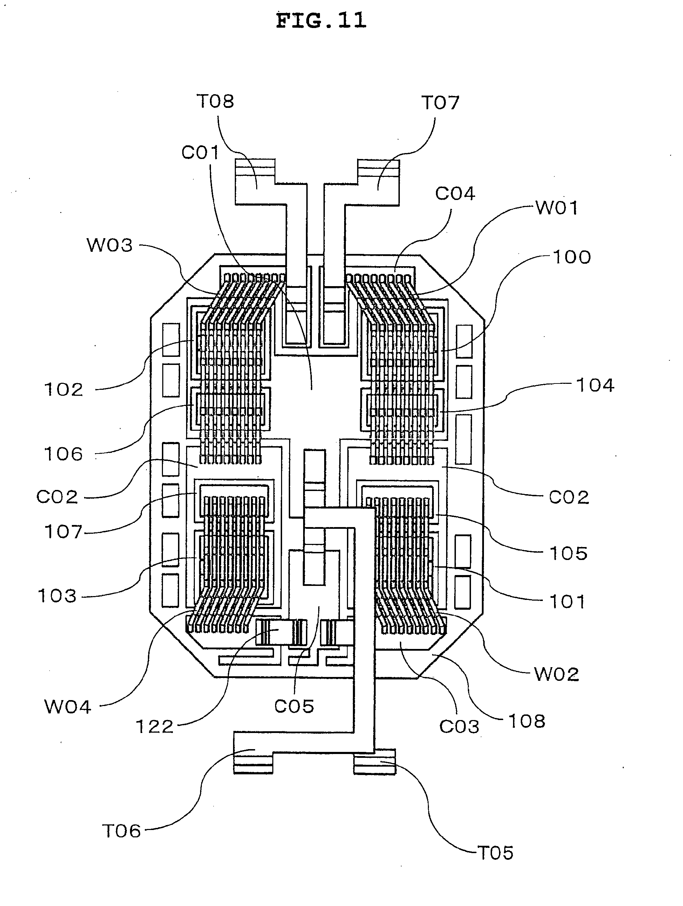

Fig. 9 is a perspective view showing the overall structure of the semiconductor power module of the third embodiment of the present invention with lid thereof removed, Fig. 10 is a perspective view showing the configuration of components of the two-phased semiconductor power module of the third embodiment, and Fig. 11 is a plain view showing the configuration of components of the semiconductor power module of the third embodiment. Here, the descriptions of the configuration with the same numerals as in Figures 1 to 6 and the parts having the same functions as in these figures are omitted.

In Fig. 10, of four power terminals T05 to T08, T05 is a positive terminal, T06 is a negative terminal, T07 and T08 are AC terminals. Power terminals T05 to T08 are connected directly to a wiring pattern by metal bonding and thus wire bonding can be omitted, making it possible to reduce resistance to current and reduce the number of wire bonding process.

Also, as shown in Fig. 10, by adopting laminated structure in which DC terminals T05 and T06 are approximated in parallel, inductance of wiring can be reduced. AC terminals T07 and T08 are not laminated because pulse current does not flow (due to AC waveform) and no voltage surge occurs, eliminating the need to reduce inductance.

Further, as shown in Fig. 11, connecting DC terminals T05 and T06 by metal bonding not wire bonding that causes slack makes it possible to dispose the bond part of each terminal around the center of insulated substrate 108 and move wiring pattern C05 shown in Fig. 1 from DC terminals T05 and T06 to the central part (contrasted with wiring pattern C05 disposed at the lowest part of insulated substrate 108 shown in Fig. 1), allowing the vertical size of insulate substrate 108 to be reduced.

Specifically, in the third embodiment, the fourth wiring pattern C05 forms the extended portion disposed between the second wiring pattern (right C02) and the third wiring pattern (left C02), negative terminal T06 that is the second DC terminal is connected to an end of the extended portion by metal bonding, positive terminal T05 that is the first DC terminal is connected to the first wiring pattern 01 by metal bonding, and both of negative terminal T06 and positive terminal T05 for metal bonding have laminated structure.

### Fourth Embodiment

A fourth embodiment of the present invention is a configuration example of a semiconductor power module whose vertical size of insulated substrate 108 is reduced by changing the arrangement of devices. Fig. 12 is a perspective view showing the wiring pattern in one board of insulated substrate 108 of the fourth embodiment and Fig. 13 is a plain view of the wiring of Fig. 12 seen from above. Here, the descriptions of the configuration with the same numerals as in Figures 9 to 11 and the parts having the same functions as in these figures are omitted.

In Fig. 13, diodes 104 and 106 of the upper arm are mounted inside IGBTs 100 and 102 of the upper arm in the fourth embodiment, and by adopting this disposition the vertical size of insulated substrate 108 can be further reduced.

Specifically, in the fourth embodiment, the first diode 104 and the second diode 107 of the first upper arm and the second upper arm are mounted, on the first wiring pattern C01, inside the first switching transistor 100 and the second switching transistor 102 in the direction perpendicular to the column center line of insulated substrate 108, the third diode 105 and the fourth diode 107 are mounted, on the second wiring pattern (right C02) and the third wiring pattern (left C02), on the upper side of the third switching transistor 101 and the fourth switching transistor 103 in the direction parallel to the column center line of insulated substrate 108.

### Fifth Embodiment

A fifth embodiment of the present invention is a configuration example of a semiconductor power module wherein the vertical size of insulate substrate 108 is reduced by shifting DC terminals T05 and T06 and AC terminals T07 and T08. Fig. 14 shows the wiring inside one board of insulated substrate 108 of the fifth embodiment and Fig. 15 is a plain view of the substrate of Fig 14 seen from above. Here, the descriptions of the configuration with the same numerals as in Figures 9 to 11 and the parts having the same functions as in these figures are omitted.

In Fig. 15, positive terminal T05 and negative terminal T06 are disposed on the upper arm side and AC terminals T07 and T08 are disposed on the lower arm. Since AC terminals T07 and T08 are directly connected to wiring pattern C02, the wiring pattern corresponding to C04 in Fig. 11 is not required (in Fig. 11, AC terminals T07 and T08 are connected to wiring pattern C02 via wiring pattern C04 and wire bonding W01 and W03)(see also the wiring circuit in Fig. 5). It is possible to further reduce the vertical size of insulated substrate 108.

Also, wiring pattern C05 is formed between wiring patterns C02 and C02 that are separately formed right and left sides of the column center line of insulated substrate 108, wiring for bonding from negative terminal T06 is connected to this wiring pattern C05, and wiring for bonding from positive terminal T05 that is a DC terminal is connected to wiring terminal C01 on which two pairs of upper arms are mounted.

Specifically, in the fifth embodiment, on one insulated substrate 108, switching transistors 100 to 103 and diodes 104 to 107 are mounted or a plurality of wiring patterns C01 to C03 and C05 serving as bonding point for wire bonding or metal bonding are formed, and when the first and second DC terminals (T05 and T06) are disposed on the edge of the semiconductor power module on the first and second upper arms, the first and second upper arms (100,104 and 102,106) are mounted respectively on the first wiring pattern C01, the first lower arm is mounted on the second wiring pattern (right C02), the second lower arm is mounted on the third wiring pattern (left C02), the fourth wiring pattern C05 is formed between the second wiring pattern (right C02) that is formed on the right and left sides of the column center line of insulated substrate 108 and the third wiring pattern (left C02), wiring for metal bonding from negative terminal T06 that is the second DC terminal is connected to the fourth wiring pattern 05, and wiring for metal bonding from positive terminal T05 that is the first DC terminal is connected to the first wiring pattern C01.

Features, components and specific details of the structures of the above-described embodiments may be exchanged or combined to form further embodiments optimized for the respective application. As far as those modifications are apparent for an expert skilled in the art they shall be disclosed implicitly by the above description without specifying explicitly every possible combination.

## Claims

1. A semiconductor power module comprising:
an insulated substrate (108) to be mounted on a metal base (127);
first to fourth switching transistors (100-103) and first to fourth diodes (104-107) to be mounted on the insulated substrate (108);
a first upper arm to which the first switching transistor (100) and the first diode (104) are connected in reverse-parallel and a second upper arm to which the second switching transistor (101) and the second diode (105) are connected in reverse-parallel;
a first lower arm to which the third switching transistor (102) and the third diode (106) are connected in reverse-parallel and a second lower arm to which the fourth switching transistor (103) and the fourth diode (107) are connected in reverse-parallel;
a first DC terminal (T01) to which one end of a series connection circuit of the first upper arm and the first lower arm and one end of a series connection circuit of the second upper arm and the second lower arm are connected;
a second DC terminal (T02) to which another end of a series connection circuit of the first upper arm and the first lower arm and another end of a series connection circuit of the second upper arm and the second lower arm are connected;
a first AC terminal (T03) to which a series connection point of the first upper arm and the first lower arm is connected; and
a second AC terminal (T04) to which a series connection point of the second upper arm and the second lower arm is connected,
**characterised in that** on the insulated substrate:
a first column composed of the first upper arm and the first lower arm and a second column composed of the second upper arm and the second lower arm are disposed rough-axisymmetrically across a column center line of the insulated substrate (108) so that the first upper arm and the second upper arm face each other perpendicularly to a column and the first lower arm and the second lower arm face each other perpendicularly to the column; and
the first DC terminal (T01) and the second DC terminal (T02) are disposed on one end of each of the first column and the second column and the first AC terminal (T03) and the second AC terminal (T04) are disposed on another end thereof.

2. The semiconductor power module according to claim 1, wherein:
on the insulated substrate (108), the switching transistor and the diode are mounted or a plurality of wiring patterns serving as bonding points for wire bonding or metal bonding are formed; and
when the first and second DC terminals (T01, T02) are disposed on an edge of a semiconductor power module (113) on the first and second lower arm side:
the first and second upper arms are respectively mounted on a first wiring pattern (C01), the first lower arm is mounted on a second wiring pattern, and the second lower arm is mounted on a third wiring pattern;
an extended portion of the first wiring pattern (C01) is formed between the second wiring pattern and the third wiring pattern which are separately formed across the column center line of the insulated substrate (108) and wiring for bonding from a positive terminal that is the first DC terminal (T01)is connected to an end of the extended portion; and
wiring for bonding from a negative terminal that is the second DC terminal (T02) is connected to a fourth wiring pattern.

3. The semiconductor power module according to claim 1, wherein:
on the insulated substrate (108), the switching transistor and the diode are mounted or a plurality of wiring patterns serving as bonding points for wire bonding or metal bonding are formed; and
when the first and second DC terminals (T01, T02) are disposed on an edge of a semiconductor power module on the first and second upper arm side:
the first and second upper arms are respectively mounted on a first wiring pattern (C01), the first lower arm is mounted on a second wiring pattern, and the second lower arm is mounted on a third wiring pattern;
a fourth wiring pattern (C03) is formed between the second wiring pattern and the third wiring pattern which are separately formed across the column center of the insulated substrate (108) and wiring for bonding from a negative terminal that is the second DC terminal (T02) is connected to the fourth wiring pattern (C03); and
wiring for bonding from a positive terminal that is the first DC terminal (T01) is connected to the first wiring pattern (C01).

4. The semiconductor power module according to claim 2, wherein:
the fourth wiring pattern (C03) forms an extended portion between the second wiring pattern and the third wiring pattern, connects from a negative terminal that is the second DC terminal (T02) to an end of the extended portion by metal bonding and connects from a positive terminal that is the first DC terminal (T01) to the first wiring pattern (C01) by metal bonding; and
both conductors for metal bonding of the negative terminal and the positive terminal are of laminated structure.

5. The semiconductor power module according to claim 2 or 4, wherein:
the first diode (104) and the second diode (105) of the first upper arm and the second upper arm are mounted inside of the first switching transistor (100) and the second switching transistor (101) in a direction perpendicular to the column center line of the insulated substrate (108) on the first wiring pattern (C01); and
the third diode (106) and the fourth diode (107) of the first lower arm and the second lower arm are mounted on the top of the third switching transistor (102) and the fourth switching transistor (103) in a direction parallel to the column center line of the insulated substrate (108) on the second wiring pattern and the third wiring pattern.

6. The semiconductor power module according to any one of claims 1 to 5, wherein a plurality of the insulated substrates (108) are disposed and a DC terminal and an AC terminal on each insulated substrate (108) are disposed together at the one end and the other end.

## Patentansprüche

1. Leistungshalbleitermodul, das umfasst:
ein isoliertes Substrat (108), das an einer Metallbasis (127) zu montieren ist;
erste bis vierte Schalttransistoren (100, 103) und erste bis vierte Dioden (104-107), die an dem isolierten Substrat (108) zu montieren sind;
einen ersten oberen Arm, mit dem der erste Schalttransistor (100) und die erste Diode (104) antiparallel verbunden sind, und einen zweiten oberen Arm, mit dem der zweite Schalttransistor (101) und die zweite Diode (105) antiparallel verbunden sind;
einen ersten unteren Arm, mit dem der dritte Schalttransistor (102) und die dritte Diode (106) antiparallel verbunden sind, und einen zweiten unteren Arm, mit dem der vierte Schalttransistor (103) und die vierte Diode (107) antiparallel verbunden sind;
einen ersten Gleichspannungsanschluss (T01), mit dem ein Ende einer Reihenschaltung des ersten oberen Arms und des ersten unteren Arms und ein Ende einer Reihenschaltung des zweiten oberen Arms und des zweiten unteren Arms verbunden sind;
einen zweiten Gleichspannungsanschluss (T02), mit dem ein weiteres Ende einer Reihenschaltung des ersten oberen Arms und des ersten unteren Arms und ein weiteres Ende einer Reihenschaltung des zweiten oberen Arms und des zweiten unteren Arms verbunden ist;
einen ersten Wechselspannungsanschluss (T03), mit dem ein Reihenschaltungspunkt des ersten oberen Arms und des ersten unteren Arms verbunden ist; und
einen zweiten Wechselspannungsanschluss (T04), mit dem ein Reihenschaltungspunkt des zweiten oberen Arms und des zweiten unteren Arms verbunden ist,
**dadurch gekennzeichnet, dass** auf dem isolierten Substrat:
eine erste Säule, die aus dem ersten oberen Arm und dem ersten unteren Arm gebildet ist, und eine zweite Säule, die aus dem zweiten oberen Arm und aus dem zweiten unteren Arm gebildet ist, im Wesentlichen achsensymmetrisch über eine Säulenmittellinie des isolierten Substrats (108) angeordnet sind, so dass der erste obere Arm und der zweite obere Arm senkrecht zu einer Säule einander zugewandt sind und der erste untere Arm und der zweite untere Arm senkrecht zu der Säule einander zugewandt sind; und
der erste Gleichspannungsanschluss (T01) und der zweite Gleichspannungsanschluss (T02) an einem Ende der ersten Säule und der zweiten Säule angeordnet sind und der erste Wechselspannungsanschluss (T03) und der zweite Wechselspannungsanschluss (T04) an einem weiteren Ende hiervon angeordnet sind.

2. Leistungshalbleitermodul nach Anspruch 1, wobei:
auf dem isolierten Substrat (108) der Schalttransistor und die Diode montiert sind oder mehrere Verdrahtungsmuster, die als Kontaktierungspunkte für eine Drahtkontaktierung oder eine Metallkontaktierung dienen, ausgebildet sind; und
dann, wenn der erste und der zweite Gleichspannungsanschluss (T01, T02) an einer Kante eines Leistungshalbleitermoduls (113) auf Seiten des ersten und des zweiten unteren Arms angeordnet sind:
der erste und der zweite obere Arm jeweils auf einem ersten Verdrahtungsmuster (C01) montiert sind, der erste untere Arm auf einem zweiten Verdrahtungsmuster montiert ist und der zweite untere Arm auf einem dritten Verdrahtungsmuster montiert ist;
ein verlängerter Abschnitt des ersten Verdrahtungsmusters (C01) zwischen dem zweiten Verdrahtungsmuster und dem dritten Verdrahtungsmuster, die über die Säulenmittellinie des isolierten Substrats (108) hinweg getrennt ausgebildet sind, gebildet ist und eine Verdrahtung für die Kontaktierung von einem positiven Anschluss, der der erste Gleichspannungsanschluss (T01) ist, mit einem Ende des verlängerten Abschnitts verbunden ist; und
eine Verdrahtung für die Kontaktierung von einem negativen Anschluss, der der zweite Gleichspannungsanschluss (T02) ist, mit einem vierten Verdrahtungsmuster verbunden ist.

3. Leistungshalbleitermodul nach Anspruch 1, wobei:
auf dem isolierten Substrat (108) der Schalttransistor oder die Diode montiert sind oder mehrere Verdrahtungsmuster, die als Kontaktierungspunkte für eine Drahtkontaktierung oder Metallkontaktierung dienen, ausgebildet sind; und
dann, wenn der erste und der zweite Gleichspannungsanschluss (T01, T02) an einer Kante eines Leistungshalbleitermoduls auf Seiten des ersten und des zweiten oberen Arms angeordnet sind:
der erste und der zweite obere Arm jeweils auf einem ersten Verdrahtungsmuster (C01) montiert sind, der erste untere Arm auf einem zweiten Verdrahtungsmuster montiert ist und der zweite untere Arm auf einem dritten Verdrahtungsmuster montiert ist;
ein viertes Verdrahtungsmuster (C03) zwischen dem zweiten Verdrahtungsmuster und dem dritten Verdrahtungsmuster, die über die Säulenmitte des isolierten Substrats (108) hinweg getrennt ausgebildet sind, gebildet ist und eine Verdrahtung für die Kontaktierung von einem negativen Anschluss, der der zweite Gleichspannungsanschluss (T02) ist, mit dem vierten Verdrahtungsmuster (C03) verbunden ist; und
eine Verdrahtung für die Kontaktierung von einem positiven Anschluss, der der erste Gleichspannungsanschluss (T01) ist, mit dem ersten Verdrahtungsmuster verbunden ist.

4. Leistungshalbleitermodul nach Anspruch 2, wobei:
das vierte Verdrahtungsmuster (C03) einen verlängerten Abschnitt zwischen dem zweiten Verdrahtungsmuster und dem dritten Verdrahtungsmuster bildet, von einem negativen Anschluss, der der zweite Gleichspannungsanschluss (T02) ist, mit einem Ende des verlängerten Abschnitts durch eine Metallkontaktierung verbunden ist und von einem positiven Anschluss, der der erste Gleichspannungsanschluss (T01) ist, mit dem ersten Verdrahtungsmuster (C01) durch eine Metallkontaktierung verbunden ist; und
beide Leiter für die Metallkontaktierung des negativen Anschlusses und des positiven Anschlusses eine laminierte Struktur aufweisen.

5. Leistungshalbleitermodul nach Anspruch 2 oder 4, wobei:
die erste Diode (104) und die zweite Diode (105) des ersten oberen Arms und des zweiten oberen Arms innerhalb des ersten Schalttransistors (100) und des zweiten Schalttransistors (101) in einer Richtung senkrecht zu der Säulenmittellinie des isolierten Substrats (108) auf dem ersten Verdrahtungsmuster (C01) montiert sind; und
die dritte Diode (106) und die vierte Diode (107) des ersten unteren Arms und des zweiten unteren Arms auf der Oberseite des dritten Schalttransistors (102) und des vierten Schalttransistors (103) in einer Richtung parallel zu der Säulenmittellinie des isolierten Substrats (108) auf dem zweiten Verdrahtungsmuster und dem dritten Verdrahtungsmuster montiert sind.

6. Leistungshalbleitermodul nach einem der Ansprüche 1 bis 5, wobei mehrere isolierte Substrate (108) angeordnet sind und ein Gleichspannungsanschluss und ein Wechselspannungsanschluss auf jedem isolierten Substrat (108) gemeinsam an dem einen Ende und dem anderem Ende angeordnet sind.

## Revendications

1. Module de puissance à semi-conducteurs, comprenant :
un substrat isolé (108) à monter sur une base en métal (127) ;
un premier à un quatrième transistor de commutation (100-103) et une première à une quatrième diode (104-107) à monter sur le substrat isolé (108) ;
un premier bras supérieur auquel sont connectés le premier transistor de commutation (100) et la première diode (104) de manière inverse/parallèle et un second bras supérieur auquel sont connectés le second transistor de commutation (101) et la seconde diode (105) de manière inverse/parallèle ;
un premier bras inférieur auquel sont connectés le troisième transistor de commutation (102) et la troisième diode (106) de manière inverse/parallèle et un second bras inférieur auquel sont connectés le quatrième transistor de commutation (103) et la quatrième diode (107) de manière inverse/parallèle ;
une première borne à courant continu (T01) à laquelle sont connectés une extrémité d'un circuit connecté en série du premier bras supérieur et du premier bras inférieur, et une extrémité d'un circuit connecté en série du second bras supérieur et du second bras inférieur ;
une seconde borne à courant continu (T02) à laquelle sont connectés une autre extrémité d'un circuit connecté en série du premier bras supérieur et du premier bras inférieur, et une autre extrémité d'un circuit connecté en série du second bras supérieur et du second bras inférieur ;
une première borne à courant alternatif (T03) à laquelle est connecté un point de connexion en série du premier bras supérieur et du premier bras inférieur ; et
une seconde borne à courant alternatif (T04) à laquelle est connecté un
point de connexion en série du second bras supérieur et du second bras inférieur,
**caractérisé en ce que**, sur le substrat isolé :
une première colonne composée du premier bras supérieur et du premier bras inférieur et une seconde colonne composée du second bras supérieur et du second bras inférieur sont disposées en gros à symétrie axiale de part et d'autre d'une ligne centrale de colonne du substrat isolé (108) de telle façon que le premier bras supérieur et le second bras supérieur se font mutuellement face perpendiculairement à une colonne et que le premier bras inférieur et le second bras inférieur se font mutuellement face perpendiculairement à la colonne ; et
la première borne à courant continu (T01) et la seconde borne à courant continu (T02) sont disposées sur une extrémité de chacune de la première colonne et de la seconde colonne, et la première borne à courant alternatif (T03) et la seconde borne à courant alternatif (T04) sont disposées sur une autre extrémité de celles-ci.

2. Module de puissance à semi-conducteurs selon la revendication 1, dans lequel :
sur le substrat isolé (108), le transistor de commutation et la diode sont montés, ou bien une pluralité de motifs de câblage servant de points de bonding pour un bonding sur fil ou un bonding sur métal sont formés ;
et
quand la première et la seconde borne à courant continu (T01, T02) sont disposées sur une bordure d'un module de puissance à semi-conducteurs (113) sur le côté du premier bras inférieur et du second bras inférieur :
le premier bras supérieur et le second bras supérieur sont respectivement montés sur un premier motif de câblage (C01), le premier bras inférieur est monté sur un second motif de câblage, et le second bras inférieur est monté sur un troisième motif de câblage ;
une portion en extension du premier motif de câblage (C01) est formée entre le second motif de câblage et le troisième motif de câblage qui sont formés séparément de part et d'autre de la ligne centrale de colonne du substrat isolé (108), et un fil de bonding depuis une borne positive qui est la première borne à courant continu (T01) est connecté à une extrémité de la portion en extension ; et
un fil de bonding depuis une borne négative qui est la seconde borne à courant continu (T02) est connecté à un quatrième motif de câblage.

3. Module de puissance à semi-conducteurs selon la revendication 1, dans lequel :
sur le substrat isolé (108), le transistor de commutation et la diode sont montés, ou bien une pluralité de motifs de câblage servant de points de bonding pour un bonding sur fil ou un bonding sur métal sont formés ; et
quand la première et la seconde borne à courant continu (T01, T02) sont disposées sur une bordure d'un module de puissance à semi-conducteurs sur le côté du premier bras supérieur et du second bras supérieur :
le premier bras supérieur et le second bras supérieur sont respectivement montés sur un premier motif de câblage (C01), le premier bras inférieur est monté sur un second motif de câblage, et le second bras inférieur est monté sur un troisième motif de câblage ;
un quatrième motif de câblage (C03) est formé entre le second motif de câblage et le troisième motif de câblage qui sont formés séparément de part et d'autre du centre de colonne du substrat isolé (108), et un fil de bonding depuis une borne négative qui est la seconde borne à courant continu (T02) est connecté au quatrième motif de câblage (C03) ; et
un fil de bonding depuis une borne positive qui est la première borne à courant continu (T01) est connecté au premier motif de câblage (C01).

4. Module de puissance à semi-conducteurs selon la revendication 2, dans lequel
le quatrième motif de câblage (C03) forme une portion en extension entre le second motif de câblage et le troisième motif de câblage, assure une connexion depuis une borne négative qui est la seconde borne à courant continu (T02) à une extrémité de la portion en extension par bonding sur métal, et assure une connexion depuis une borne positive qui est la première borne à courant continu (T01) et le premier motif de câblage (COA) par bonding sur métal ; et
les deux conducteurs pour bonding sur métal de la borne négative et de la borne positive ont une structure stratifiée.

5. Module de puissance à semi-conducteurs selon la revendication 2 ou 4, dans lequel :
la première diode (104) et la seconde diode (105) du premier bras supérieur et du second bras supérieur sont montées à l'intérieur du premier transistor de commutation (100) et du second transistor de commutation (101) dans une direction perpendiculaire à la ligne centrale de colonne du substrat isolé (108) sur le premier motif de câblage (C01) ; et
la troisième diode (106) et la quatrième diode (107) du premier bras inférieur et du second bras inférieur sont montées sur le sommet du troisième transistor de commutation (102) et du quatrième transistor de commutation (103) dans une direction parallèle à la ligne centrale de colonne du substrat isolé (108) sur le second motif de câblage et le troisième motif de câblage.

6. Module de puissance à semi-conducteurs selon l'une quelconque des revendications 1 à 5, dans lequel une pluralité de substrats isolés (108) sont disposés et une borne à courant continu et une borne à courant alternatif sur chaque substrat isolé (108) sont disposées ensemble à une extrémité et à l'autre extrémité.
